# EUROPÄISCHE PATENTSCHRIFT

(11) **EP 2 449 394 B1**
(45) Veröffentlichungstag und Bekanntmachung des Hinweises auf die Patenterteilung: **21.08.2013**
(21) Anmeldenummer: 10715871.9
(22) Anmeldetag: 30.04.2010
(51) Int. Cl.: G01R 33/07, H01L 43/04, H01L 43/06, H01L 43/14

(54) **HALL-SENSORELEMENT UND VERFAHREN ZUR MESSUNG EINES MAGNETFELDS**
HALL SENSOR ELEMENT AND METHOD FOR MEASURING A MAGNETIC FIELD
ÉLÉMENT CAPTEUR À EFFET HALL ET PROCÉDÉ DE MESURE D'UN CHAMP MAGNÉTIQUE

(30) Priorität: 30.06.2009 DE 102009027338
(43) Veröffentlichungstag der Anmeldung: 09.05.2012
(73) Patentinhaber: Robert Bosch GmbH, 70442 Stuttgart (DE)
(72) Erfinder: HELLWIG, Wolfgang, 72810 Gomaringen (DE); TILS, Valentin, 72147 Nehren (DE); EBERHARDT, Friedemann, 72762 Reutlingen (DE); RUEBENACKE, Stefan, 72762 Reutlingen (DE)
(86) Internationale Anmeldenummer: PCT/EP2010/055904
(87) Internationale Veröffentlichungsnummer: WO 2011/000601

(56) Entgegenhaltungen:
- US-A- 4 829 352
- US-A1- 2009 256 559

## Beschreibung

### Stand der Technik

Die vorliegende Erfindung betrifft ein Hall-Sensorelement, das ein Substrat mit einer Hauptoberfläche aufweist. Ferner betrifft die Erfindung Verfahren zur Messung, insbesondere mehrdimensionalen, Messung, eines Magnetfeldes mittels eines derartigen Hall-Sensorelements.

Auf dem Hall-Effekt beruhende Hall-Sensorelemente werden in weiten Bereichen der Technik sowohl zur Messung der magnetischer Flussdichte von Magnetfeldern als auch zur kontaktlosen Messung von Strömen sowie als berührungslose Signalgeber z.B. zur verschleißfreien Erfassung der Stellung von Wellen, Stellgliedern u. ä. verwendet. Ein Hall-Sensorelement ist im Allgemeinen aus einem Halbleitersubstratplättchen mit vier Kontaktanschlüssen zur elektrischen Verbindung mit einer externen Ansteuerschaltung aufgebaut. Von den vier Kontaktanschlüssen sind zwei Kontaktanschlüsse zur Einprägung eines Betriebsstroms durch einen aktiven Halbleiterbereich des Sensorelements vorgesehen, während die anderen beiden Kontaktanschlüsse dazu dienen, die Hall-Spannung zu erfassen. Die Hall-Spannung ergibt sich senkrecht zur Richtung des magnetischen Flusses und des Stromflusses im aktiven Halbleitergebiet.

Die DE 10 2006 017 910 A1 offenbart ein sogenanntes horizontales Hall-Sensorelement, bei dem Betriebsstrom und Hall-Spannung horizontal in der Ebene der Hauptoberfläche des Halbleitersubstrats verlaufen. Horizontale Hall-Sensorelemente sind relativ einfach mit herkömmlichen CMOS-Prozessen zur Herstellung von Halbleiterstrukturen herstellbar und sensieren senkrecht zur Substratebene gerichtete Flussdichtekomponenten von Magnetfeldern. Eine mehrdimensionale Messung von Magnetfeldern, wie sie z.B. bei Kompassanwendungen benötigt wird, ist mit horizontalen Hall-Sensorelementen möglich, indem mehrere diskrete Halbleitersubstratplättchen, auf denen jeweils ein horizontales Hall-Sensorelement ausgebildet ist, senkrecht zu unterschiedlichen Raumrichtungen angeordnet werden, was jedoch mit hohen Herstellungskosten und Raumbedarf verbunden ist.

Ebenfalls in der DE 10 2006 017 910 A1 offenbart ist ein vertikales Hall-Sensorelement, bei dem Betriebsstrom und Hall-Spannung in einer zur Substratoberfläche vertikalen Ebene verlaufen, sodass parallel zur Substratebene gerichtete Flussdichtekomponenten von Magnetfeldern sensiert werden. Das vertikale Hall-Sensorelement umfasst eine Mehrzahl von Kontaktbereichen an der Hauptoberfläche eines sich in das Substrat erstreckenden Halbleiterbereichs. Dabei sind zwischen benachbarten Kontaktbereichen nichtleitende Barrierenbereiche angeordnet, die sich ausgehend von der Hauptoberfläche in den Halbleiterbereich erstrecken, um einen zwischen zwei Kontaktbereichen in dem Halbleiterbereich eingespeisten Betriebsstrom entfernt von der Hauptoberfläche zu halten. Hierbei stellt sich jedoch das Problem, dass die Leitfähigkeit für die Ladungsträger in tieferen Bereichen des aktiven Halbleiterbereichs deutlich geringer ist als an der Oberfläche des Halbleitermaterials, vorzugsweise Silizium, sodass ein derartiges vertikale Hall-Sensorelement nur geringe Effizienz aufweist. Die US 4829352 US 5057890 und US 4987467 offenbaren vertikale Hall-Elemente.

Eine Struktur mit mehreren horizontalen Hall-Sensorelementen auf einem einzigen Halbleitersubstratplättchen und einer zusätzlichen strukturierten ferromagnetischen Schicht, die zur Oberfläche des Halbleitersubstratplättchens parallele Magnetfeldkomponenten in lokal senkrechte Felder umlenkt, wird von C. Schott et al. vorgeschlagen, erfordert jedoch einen hohen Fertigungsaufwand, da die Struktur mit herkömmlichen Prozessen zur Herstellung von Halbleiterstrukturen nicht herstellbar ist (C. Schott et al., CMOS Single-Chip Electronic Compass with Microcontroller, in: H. Casier et al. [Hrsg.], Analog Circuit Design: Sensors, Actuators and Power Drivers; Integrated Power Amplifiers from Wireline to RF; Very High Frequency Front Ends, S. 55-69, Springer Science + Business Media B. V., 2008).

Es ist daher wünschenswert, eine effiziente Messung von horizontal zur Ebene eines Halbleitersubstratplättchens verlaufenden Magnetfeldkomponenten mittels einer kostengünstig auf dem Halbleitersubstratplättchen herstellbaren Struktur zu ermöglichen.

### Offenbarung der Erfindung

Demgemäß vorgesehen ist ein Hall-Sensorelement mit einem Substrat, das eine Hauptoberfläche aufweist. Ein elektrisch leitfähiges aktives Gebiet erstreckt sich von der Hauptoberfläche in das Substrat. Das Hall-Sensorelement weist eine elektrisch leitfähige erste vergrabene Schicht im Substrat auf, die das aktive Gebiet an einer ersten unteren Kontaktfläche kontaktiert. Hierbei impliziert der Ausdruck "im Substrat vergraben", dass die Schicht eine vom Substrat unterschiedliche Beschaffenheit aufweist und von der Hauptoberfläche beabstandet angeordnet ist. Mit anderen Worten befindet sich zwischen der ersten vergrabenen Schicht und der Hauptoberfläche ein die Schicht bedeckender Substratbereich. Unter der vergrabenen Schicht kann sich z.B. das Substrat in einem weiteren Substratbereich fortsetzen, der gleich oder abweichend von dem die Schicht bedeckenden Substratbereich ausgebildet sein kann, oder die erste vergrabene Schicht ist z.B. von einer der Hauptoberfläche gegenüberliegenden Rückoberfläche her zugänglich.

Die Kontaktierung des aktiven Gebiets von der Seite der vergrabenen Schicht her ermöglicht, zumindest einen der Kontaktanschlüsse des Hall-Sensorelements, mit denen der Betriebsstrom eingeprägt und die Hall-Spannung abgegriffen werden, am Ort der unteren Kontaktfläche vorzusehen, d.h. aufgrund der im Substrat vergrabenen Lage der vergrabenen Schicht an einem von der Hauptoberfläche beabstandeten Ort. Je nachdem, ob die erste untere Kontaktfläche zur Einprägung des Betriebsstroms oder/und zum Abgriff der Hall-Spannung beschaltet wird, wird auf diese Weise ermöglicht, dass die Flussrichtung des Betriebsstroms bzw. die Abgriffsrichtung der Hall-Spannung mit einer Richtungskomponente vertikal zur Hauptoberfläche verläuft, zwischen der ersten unteren Kontaktfläche und einem weiteren Kontaktanschluss, der sich z.B. an der leicht zugänglichen Hauptoberfläche des Halbleiterbereichs befinden kann. Die vertikale Richtungskomponente der Flussrichtung des Betriebsstroms oder/und der Abgriffsrichtung der Hall-Spannung hat zur Folge, dass die von beiden aufgespannte Messebene geneigt oder rechtwinklig zur Hauptoberfläche des Substrats verläuft und das Hall-Sensorelement für zur Hauptoberfläche parallele Magnetfelder empfindlich ist. Das erfindungsgemäße Hall-Sensorelement ermöglicht damit eine von der Lage der Hauptoberfläche unabhängige Ausrichtung von Messebenen, sodass bei geeigneter Festlegung zweier oder dreier Messebenen mit linear unabhängigen Normalenvektoren die Verwendung zur zwei- bzw. dreidimensionalen Messung von Magnetfeldern ermöglicht ist.

Das erfinderische Hall-Sensorelement ermöglicht aufgrund der von der Hauptoberfläche beabstandeten Lage der unteren Kontaktfläche, von der unteren Kontaktfläche aus der Betriebsstrom wesentlich geradlinig einzuprägen und/oder die Hall Spannung in gerader Linie abzugreifen und arbeitet daher hocheffizient. Insbesondere ist nicht erforderlich, die Flussrichtung des Betriebsstroms im aktiven Bereich, die Abgriffsrichtung der Hall-Spannung oder die Richtung der Feldlinien in einen die Effizienz beeinträchtigenden gekrümmten Verlauf zu zwingen.

Das erfinderische Hall-Sensorelement ist vollständig mit herkömmlichen Prozessen zur Hetstellung von Halbleiterstrukturen herstellbar, z.B. mittels sogenannter Smart-Power-Technologien. Es ist daher äußerst kostengünstig und lässt sich insbesondere vorteilhaft mit weiteren Hall-Sensorelementen und/oder anderen Leistungs-, Analog- und Digitalfunktionen auf einem Chip integrieren. Über herkömmliche Prozesse hinausgehende, die Herstellung verteuernde Schritte wie z.B. die Ausbildung ferromagnetischer Schichten sind unnötig.

Gemäß einer bevorzugten Weiterbildung ist das Substrat ein Halbleitersubstrat, und das aktive Gebiet ist ein Halbleitergebiet eines ersten Leitfähigkeitstyps. Hierdurch wird eine hohe Hall-Spannung generiert, und das Hall-Sensorelement lässt sich effizient in bestehende mikroelektronische Herstellungsverfahren einbinden und mit weiteren Halbleiterfunktionen auf dem Halbleitersubstrat integrieren.

Gemäß einer bevorzugten Weiterbildung weist das Hall-Sensorelement eine erste obere Kontaktelektrode auf, die das aktive Gebiet an der Hauptoberfläche kontaktiert. An der Hauptoberfläche ist die Kontaktelektrode besonders einfach herzustellen und benötigt wenig Substratfläche.

Gemäß einer bevorzugten Weiterbildung ist die erste obere Kontaktelektrode wesentlich senkrecht über der ersten unteren Kontaktfläche angeordnet. So wird eine besonders geringe Fläche in der Ebene der Hauptoberfläche benötigt und gleichzeitig eine hohe Empfindlichkeit für parallel zur Hauptoberfläche verlaufende Magnetfelder erreicht. Gemäß einer alternativen bevorzugten Weiterbildung ist die erste obere Kontaktelektrode diagonal zur ersten unteren Kontaktfläche versetzt angeordnet. Dies ermöglicht eine höhere Empfindlichkeit für schräg zur Hauptoberfläche einfallende Magnetfelder.

Gemäß einer bevorzugten Weiterbildung weist das Hall-Sensorelement eine zweite und eine dritte obere Kontaktelektrode auf, die jeweils das aktive Gebiet an der Hauptoberfläche kontaktieren, sodass insgesamt vier Kontaktanschlüsse für den Betrieb des Hall-Sensorelements ausgebildet sind. An der Hauptoberfläche sind die Kontaktelektroden besonders einfach zugänglich, sodass das Hall-Sensorelement auf einfache Weise beschaltet werden kann.

Gemäß einer alternativen bevorzugten Weiterbildung weist das Hall-Sensorelement eine zweite elektrisch leitfähige vergrabene Schicht, die das aktive Gebiet an einer zweiten unteren Kontaktfläche kontaktiert, und eine zweite obere Kontaktelektrode auf, die das aktive Gebiet an der Hauptoberfläche kontaktiert. Die unteren Kontaktflächen und oberen Kontaktelektroden sind dabei derart angeordnet, dass eine erste Verbindungslinie zwischen der ersten unteren Kontaktfläche und der ersten oberen Kontaktelektrode geneigt zu einer zweiten Verbindungslinie zwischen der zweiten unteren Kontaktfläche und der zweiten oberen Kontaktelektrode verläuft. Der Begriff "Verbindungslinie" ist hier im Sinne eines geometrischen Pfades durch das aktive Gebiet gemeint, entlang dessen elektrischer Strom durch das aktive Gebiet fließen kann oder eine Spannung abgegriffen werden kann. Die Neigung der Verbindungslinien zueinander ermöglicht, zur Einprägung des Betriebsstroms und zum Abgriff der Hall-Spannung auf symmetrische Weise jeweils eine der unteren Kontaktflächen und die obere Kontaktelektrode gleicher Nummerierung zu verwenden. Die Beschaltung kann aufgrund der Symmetrie ohne weiteres im Rahmen eines sogenannten spinning-current-Verfahrens periodisch umgekehrt werden, um die Messgenauigkeit zu erhöhen.

Vorzugsweise weist das Hall-Sensorelement eine dritte und vierte elektrisch leitfähige vergrabene Schicht auf, die das aktive Gebiet an einer jeweils zugehörigen dritten und vierten unteren Kontaktfläche kontaktieren, sowie ferner eine dritte und vierte obere Kontaktelektrode, die das aktive Gebiet an der Hauptoberfläche kontaktieren. Die unteren Kontaktflächen und oberen Kontaktelektroden sind dabei derart angeordnet, dass eine von der ersten und zweiten Verbindungslinie aufgespannte erste Ebene geneigt zu einer zweiten Ebene verläuft, die von einer dritten und einer vierten Verbindungslinie aufgespannt wird. Die dritte Verbindungslinie verbindet die dritte untere Kontaktfläche mit der dritten oberen Kontaktelektrode, während die vierte Verbindungslinie die vierte untere Kontaktfläche mit der vierten oberen Kontaktfläche verbindet. Dies ermöglicht mit dem Hall-Sensorelement je nach Beschaltung, die bei Bedarf z.B. periodisch änderbar ist, sowohl Magnetfeldkomponenten zu messen, die senkrecht auf der ersten Ebene stehen, als auch solche Magnetfeldkomponenten, die senkrecht auf der zweiten Ebene stehen. Dies ist insbesondere auch dann möglich, wenn die zweite und dritte vergrabene Schicht, die zweite und dritte untere Kontaktfläche, die zweite und dritte obere Kontaktelektrode und folglich auch die zweite und dritte Verbindungslinie jeweils miteinander identisch ausgebildet sind. Zur Erhöhung der Messgenauigkeit innerhalb der einzelnen Ebenen können ferner spinning-current-Verfahren angewendet werden.

Unter einem weiteren Gesichtspunkt schafft die Erfindung ein Verfahren zur Messung eines Magnetfeldes mittels eines derartigen Hall-Sensorelements, bei dem ein elektrischer Messstrom zwischen einer ersten oberen Kontaktelektrode an der Hauptoberfläche und der ersten unteren Kontaktfläche durch das aktive Gebiet geleitet wird. Hierbei ist unter der Bezeichnung "an der Hauptoberfläche" ein Ort nahe der Hauptoberfläche zu verstehen, verglichen mit dem Abstand der ersten unteren Kontaktfläche zur Hauptoberfläche. Am aktiven Gebiet wird entlang einer Strecke, die geneigt zu einer Verbindungslinie zwischen der ersten unteren Kontaktfläche und der ersten oberen Kontaktelektrode verläuft, eine Hall-Spannung abgegriffen. Beispielsweise kann die Strecke in dem Bereich, wo sie die Verbindungslinie kreuzt, rechtwinklig oder in einem schrägen Winkel zu dieser verlaufen. Gemäß einem alternativen erfindungsgemäßen Messverfahren wird ein Messstrom über eine solche Strecke durch das aktive Gebiet geleitet und eine Hall-Spannung zwischen der ersten oberen Kontaktelektrode und der ersten unteren Kontaktfläche abgegriffen.

### Kurze Beschreibung der Zeichnungen

Die vorliegende Erfindung wird nachfolgend anhand bevorzugter Ausführungsformen und beigefügter Figuren erläutert. In den Figuren zeigen:
- Fig. 1A: eine Draufsicht auf ein Hall-Sensorelement gemäß einer Ausführungsform der Erfindung;
- Fig. 1B-C: Querschnittansichten des Hall-Sensorelements aus Fig. 1A entlang zweier orthogonaler Schnittebenen;
- Fig. 2A-C: eine Draufsicht und zugehörige Querschnittansichten eines Hall-Sensorelements gemäß einer weiteren Ausführungsform;
- Fig. 3A-C: eine Draufsicht und zugehörige Querschnittansichten eines Hall-Sensorelements gemäß einer weiteren Ausführungsform;
- Fig. 4A-C: eine schematische Draufsicht und zugehörige Querschnittansichten eines Hall-Sensorelements gemäß einer weiteren Ausführungsform;
- Fig. 5: eine aufgeschnittene Perspektivansicht eines Hall-Sensorelements gemäß einer weiteren Ausführungsform mit einer Beschaltung für ein Messverfahren gemäß einer Ausführungsform;
- Fig. 6: ein perspektivisches Prinzipschema eines Messverfahrens gemäß einer weiteren Ausführungsform; und
- Fig. 7: ein Ablaufdiagramm eines Messverfahrens gemäß einer Ausführungsform.

In den Figuren bezeichnen dieselben Bezugszeichen gleiche oder funktionsgleiche Komponenten, soweit nichts Gegenteiliges angegeben ist.

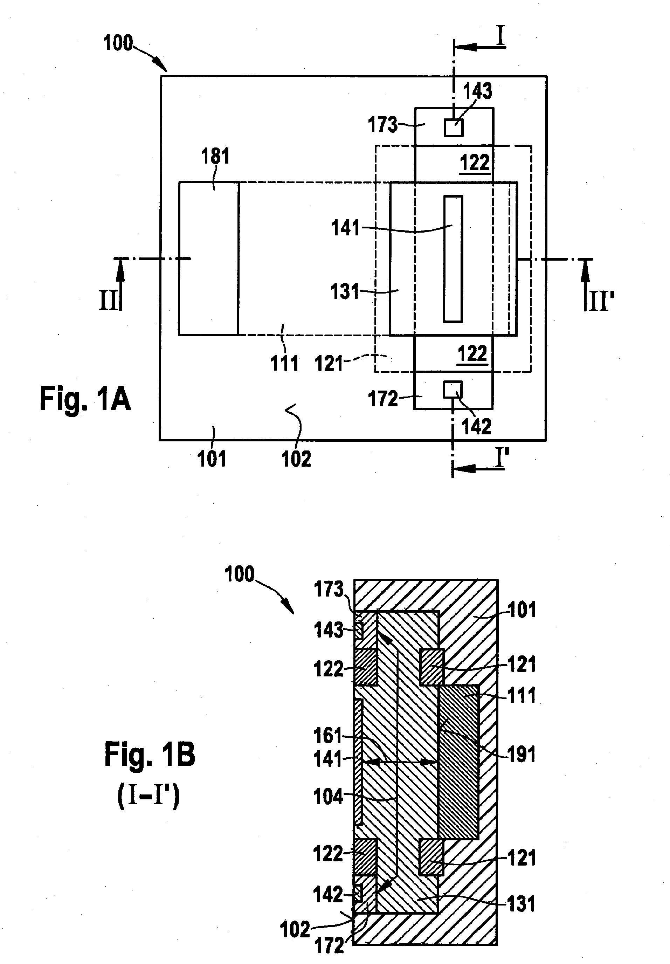

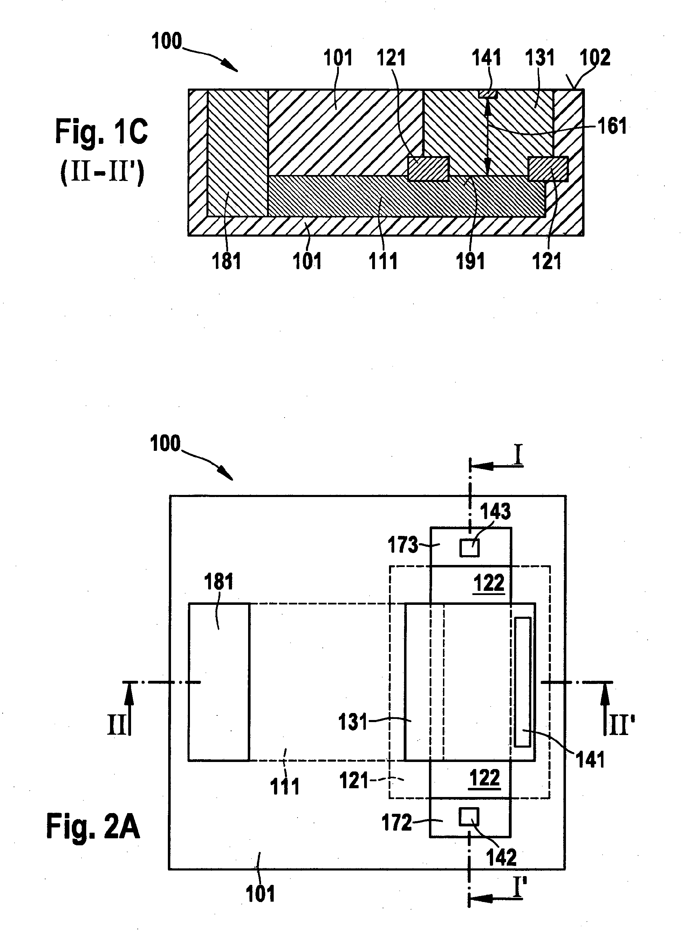

Figur 1A zeigt eine Draufsicht auf ein Hall-Sensorelement 100, das in ein Halbleitersubstrat 101 wie z.B. Silizium eingebettet ist. Die Blickrichtung des Betrachters fällt senkrecht auf eine Hauptoberfläche 102 des Substrats 101, die z.B. einen Teilausschnitt der Oberfläche eines Mikrochips bilden kann. Im Rahmen der Fertigung eines solchen Mikrochips können auf der Hauptoberfläche 102 noch weitere Materialschichten zur Abdeckung, Packung u.ä. aufgebracht sein, die hier jedoch nicht gezeigt sind. Zwei strichpunktierte Linien I-I' und II-II' markieren senkrecht zueinander und zur Hauptoberfläche 102 des Substrats 101 verlaufende Schnittebenen, zu denen entsprechende Schnittansichten in Fig. 1B bzw. Fig. 1C gezeigt sind. Gestrichelte Linien in Fig. 1A markieren Konturen von unterhalb der Hauptoberfläche 102 verborgenen Elementen 111, 121, wogegen in den Schnittansichten von Fig. 1B-C darauf verzichtet wurde, hinter der jeweiligen Schnittebene verborgene Elemente zu zeigen.

Das gezeigte Hall-Sensorelement 100 umfasst einen elektrisch leitfähigen, aktiven Halbleiterbereich 131 zur Registrierung des Hall-Effekts. Der aktive Bereich 131 erstreckt sich von der Hauptoberfläche 102 in das Substrat 101 hinein und ist mit einem ersten Leitfähigkeitstyp, p oder n, dotiert. In der Ebene der Hauptoberfläche 102 weist der aktive Bereich 131 eine in der Richtung I-I' langgestreckte Form auf. Das Substrat 101 ist schwach mit dem gegenteiligen Leitfähigkeitstyp dotiert und verfügt über eine wesentlich geringere Leitfähigkeit als der aktive Bereich 131.

In einer Ebene unterhalb der unteren Grenzfläche des aktiven Bereichs 131 weist das Hall-Sensorelement eine elektrisch leitfähige vergrabene Schicht 111 des ersten Leitfähigkeitstyps auf, d.h. mit einer Dotierung gleichen Typs wie der aktive Bereich 131. Eine derartige vergrabene Schicht kann mit herkömmlichen Halbleiterfertigungsverfahren wie z.B. Smart-Power-Prozessen ohne weiteres hergestellt werden. Die vergrabene Schicht 111 kontaktiert den aktiven Bereich elektrisch an einer unteren Kontaktfläche 191, die sich großflächig über einen zentralen Abschnitt der unteren Begrenzung des aktiven Bereichs 131 erstreckt. Eine elektrisch isolierende, rahmenförmige Trennstruktur 121 unmittelbar oberhalb der oberen Grenzfläche der vergrabenen Schicht 111 bildet eine definierte laterale Begrenzung der unteren Kontaktfläche 191. In alternativen Ausführungsformen kann die Trennstruktur 121 ganz oder teilweise entfallen. Die vergrabene Schicht 111 erstreckt sich durch das Substrat 101 bis zu einem entfernt des aktiven Bereichs 131 liegenden Ort, wo ein leitender Kontaktstöpsel 181 eine elektrische Verbindung der vergrabenen Schicht 111 bis zu einer freiliegenden Anschlussstelle an der Hauptoberfläche 102 des Substrats bereitstellt.

Es wird betont, dass der Abstand des Kontaktstöpsels 181 vom aktiven Bereich je nach Anwendung unterschiedlich lang ausgebildet sein kann und auch die gezeigte Kontaktstöpselstruktur 181 selbst rein beispielhaft als ein mögliches Mittel dargestellt ist, die vergrabene Schicht 111 mit einem elektrischen Anschluss zu versehen. In alternativen Ausführungsformen kann z.B. die vergrabene Schicht zu einer der Hauptoberfläche 102 gegenüberliegenden Rückoberfläche hin ganz oder teilweise freiliegen, sodass sie von der Rückoberfläche her direkt kontaktierbar ist, oder mit an der Rückoberfläche ausgebildeten Strukturen elektrisch verbunden sein. Beispielsweise kann in einer alternativen Ausführungsform die vergrabene Schicht von einem rückwärtigen Kontaktstöpsel kontaktiert sein, dersich von der vergrabenen Schicht 111 bis zu einer Kontaktfläche oder leitenden Struktur an der Rückoberfläche erstreckt.

Im Zentrum der an der Hauptoberfläche 102 senkrecht über der unteren Kontaktfläche 191 liegenden oberen Begrenzungsfläche des aktiven Bereichs 131 ist eine ebenfalls in der Richtung I-I' langgestreckt geformte erste obere Kontaktelektrode 141 als ein Bereich erhöhter Dotierung mit dem ersten Leitfähigkeitstyp ausgebildet. Zu beiden Seiten der ersten oberen Kontaktelektrode 141 erstreckt sich der aktive Bereich 131 in der Richtung I-I' über die Trennstruktur 121 hinaus, wo er von einer zweiten 142 und dritten 143 oberen Kontaktelektrode an der Hauptoberfläche 102 kontaktiert wird. Die exakte Lage der optionalen Trennstruktur 121, die in der vorliegenden Ausführungsform eine geradlinige elektrische Verbindung zwischen der zweiten 142 und dritten 143 oberen Kontaktelektrode einerseits und der unteren Kontaktfläche 191 andererseits verhindert, kann entsprechend den Entwurfsregeln des zur Herstellung des Hall-Sensorelements 100 verwendeten Halbleiterproduktionsverfahrens von der vorliegenden Ausführungsform abweichend gewählt sein. Die zweite 142 und dritte 143 obere Kontaktelektrode sind ebenfalls als Bereiche erhöhter Dotierung mit dem ersten Leitfähigkeitstyp ausgebildet, wobei sie jeweils von einem Flächenkontaktbereich 172, 173 mit erhöhter Dotierung mit dem ersten Leitfähigkeitstyp umgeben sind, der in der Richtung II-II' eine gleiche Breite wie die untere Kontaktfläche 191 aufweist. Die Flächenkontaktbereichen 172,173 sind von der über der unteren Kontaktfläche 191 freiliegenden oberen Begrenzungsfläche des aktiven Bereichs 131 jeweils durch eine oberhalb der Trennstruktur 121 liegende isolierende Barriere 122 so abgetrennt, dass eine elektrische Verbindung von der zweiten 142 und dritten 143 oberen Kontaktelektrode in den über der unteren Kontaktfläche 191 liegenden Abschnitt des aktiven Bereichs nur zwischen der Trennstruktur 121 und der darüberliegenden Barriere 122 besteht.

Im Betrieb des Hall-Sensorelements 100 wird eine Betriebsstromquelle z.B. an den Kontaktstöpsel 181 und die erste obere Kontaktelektrode 141 angeschlossen, sodass ein Betriebsstrom entlang der senkrecht zur Hauptoberfläche 102 durch den aktiven Bereich 131 verlaufenden ersten Verbindungslinie 161 zwischen der unteren Kontaktfläche 191 und der ersten oberen Kontaktelektrode eingeprägt wird. Bei Anliegen eines Magnetfelds parallel zur Hauptoberfläche 102 in der Richtung II-II' entsteht eine Hall-Spannung entlang einerzweiten Verbindungslinie 104 zwischen den zu den zweiten 142 und dritten 143 oberen Kontaktelektroden gehörigen Flächenkontaktbereichen 172, 173. Bei geeigneter Dimensionierung der Flächenkontaktbereiche 172, 173 kann das Hall-Sensorelement 100 auch umgekehrt betrieben werden, indem ein Betriebsstrom über die zweite 142 und dritte 143 obere Kontaktelektrode eingeprägt und eine Hall-Spannung am Kontaktstöpsel 181 und der ersten oberen Kontaktelektrode 141 abgegriffen wird. Zwischen beiden Betriebsarten kann zur Erhöhung der Genauigkeit im Rahmen eines spinning-current-Verfahrens periodisch umgeschaltet werden. Durch zwei dieser Hall-Sensorelemente 100, die z.B. auf einem gemeinsamen Substrat im Winkel zueinander angeordnet sind, lassen sich Magnetfelder in beliebigen parallel zur Hauptoberfläche verlaufenden Richtungen vermessen.

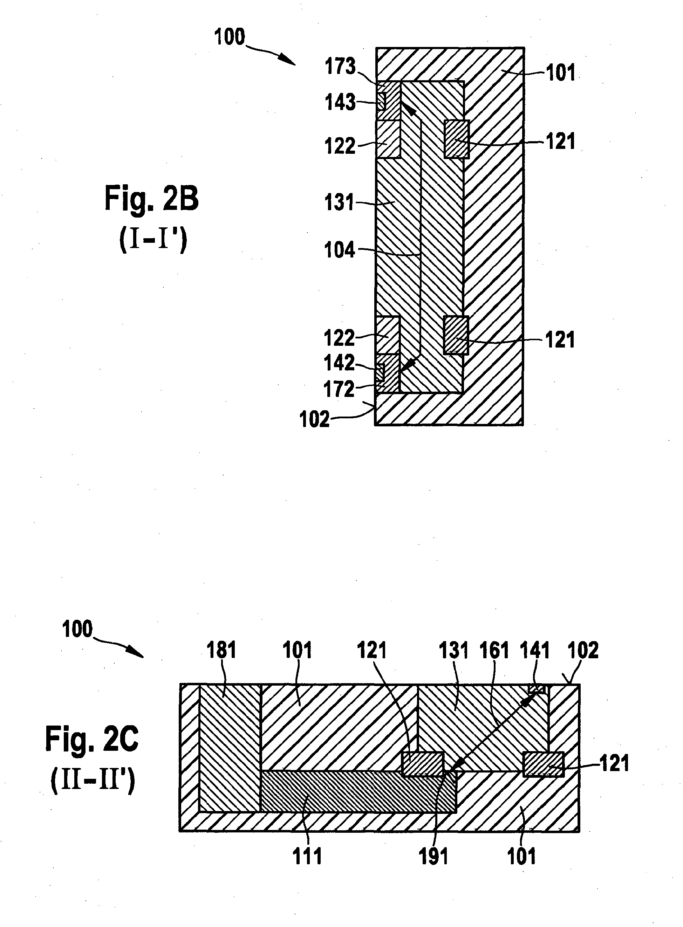

In jeweils von drei zusammengehörigen Figuren gebildeten Figurengruppen Fig. 2A-C, Fig. 3A-C und Fig. 4A-C sind weitere Beispiele für Hall-Sensorelemente 100 nach den gleichen Darstellungsprinzipien wie für Fig. 1A-C erläutert gezeigt. Zum Zusammenhang von Draufsichten und Schnittansichten sowie zur Bedeutung der strichpunktierten und gestrichelten Linien wird auf die analog gültigen Ausführungen zu Fig. 1A-C verwiesen.

Die Figuren 2A-C zeigt ein Hall-Sensorelement 100, bei dem sich wie beim Hall-Sensorelement 100 aus Fig. 1A-C die vergrabene Schicht 111 vom Kontaktstöpsel 181 aus unter der hier ebenfalls optionalen Trennstruktur 121 entlang bis an die untere Begrenzungsfläche des aktiven Bereichs 131 erstreckt, jedoch abweichend kurz hinter der Trennstruktur 121 endet, sodass die untere Kontaktfläche 191 der vergrabenen Schicht 111 zum aktiven Bereich 131 nur entlang des in Richtung des Kontaktstöpsels liegenden Randbereichs der unteren Begrenzungsfläche des aktiven Bereichs 131 gebildet ist. Weiterhin abweichend ist die erste obere Kontaktelektrode 141 am der unteren Kontaktfläche 191 diagonal gegenüberliegenden Rand des aktiven Bereichs 131 an der Hauptoberfläche 102 angeordnet, sodass die erste Verbindungslinie 161 zwischen der unteren Kontaktfläche 161 und der ersten oberen Kontaktelektrode 141 diagonal um vorzugsweise etwa 45° gegenüber der Hauptoberfläche 102 geneigt verläuft. Durch Nutzung der Diagonale weist das gezeigte Hall-Sensorelement 100 eine höhere Empfindlichkeit für schräg zur Hauptoberfläche 102 einfallende Magnetfelder auf. Aufbau und Betrieb entsprechen ansonsten dem Hall-Sensorelement 100 aus Fig. 1A-C.

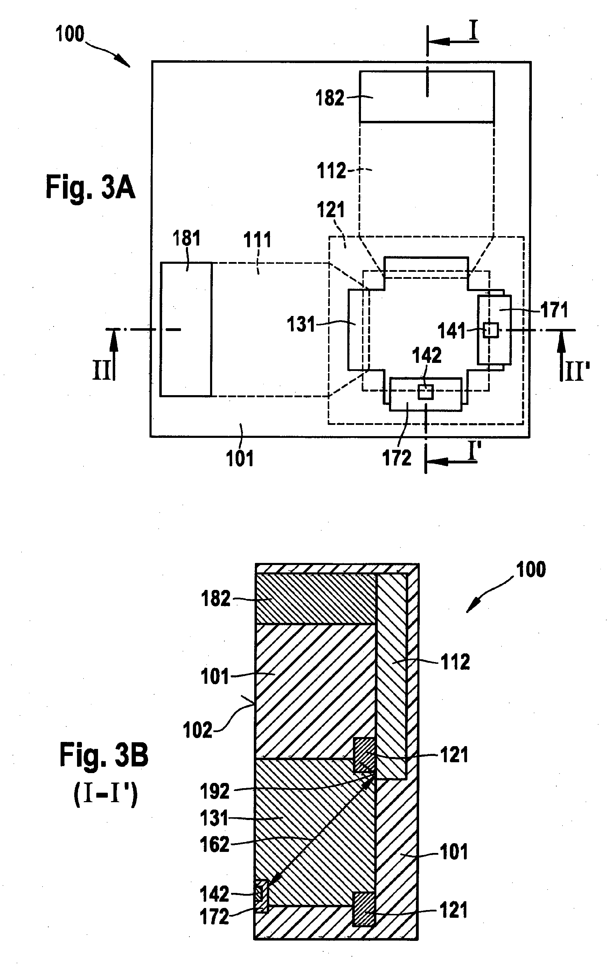

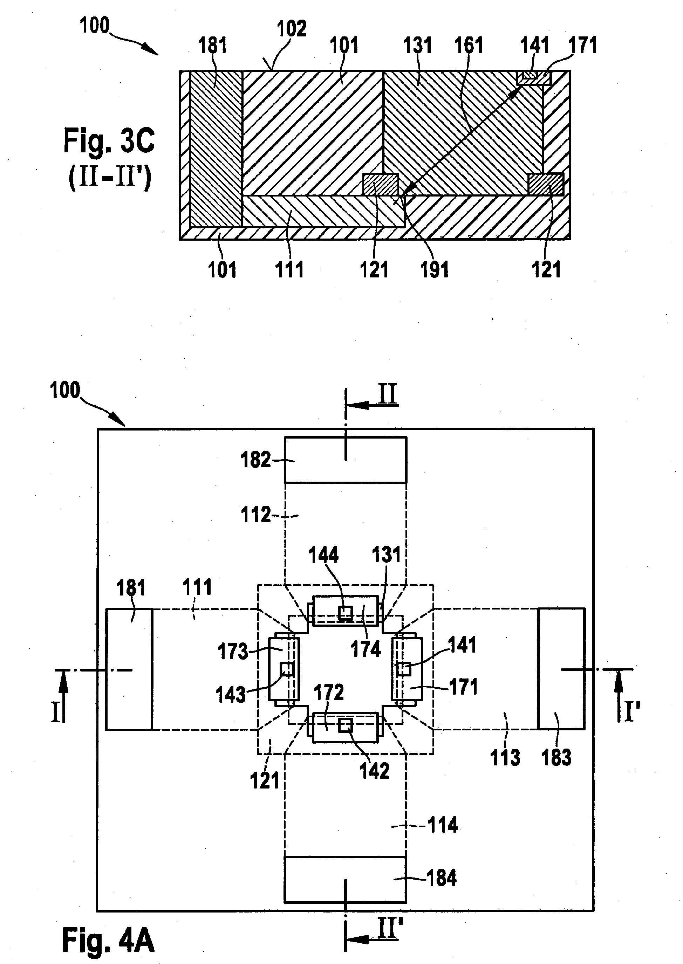

Bei dem in Fig. 3A-C gezeigten Hall-Sensorelement 100 ausgehend vom Aufbau des in Fig. 2A-C gezeigten Hall-Sensorelements ist die dort vorhandene dritte obere Kontaktelektrode ersetzt durch eine zweite vergrabene Schicht 112 mit zugehörigem zweiten Kontaktstöpsel 182 und einer zweiten unteren Kontaktfläche 192 am aktiven Bereich 131. Wie die erste Verbindungslinie 161 verläuft auch die zweite Verbindungslinie 162 diagonal um vorzugsweise 45° zur Hauptoberfläche 102 geneigt durch den aktiven Bereich 131. Aufgrund ihrer Symmetrie ist dieses Hall-Sensorelement 100 ohne weitere Maßnahmen fähig zum spinning-current-Betrieb.

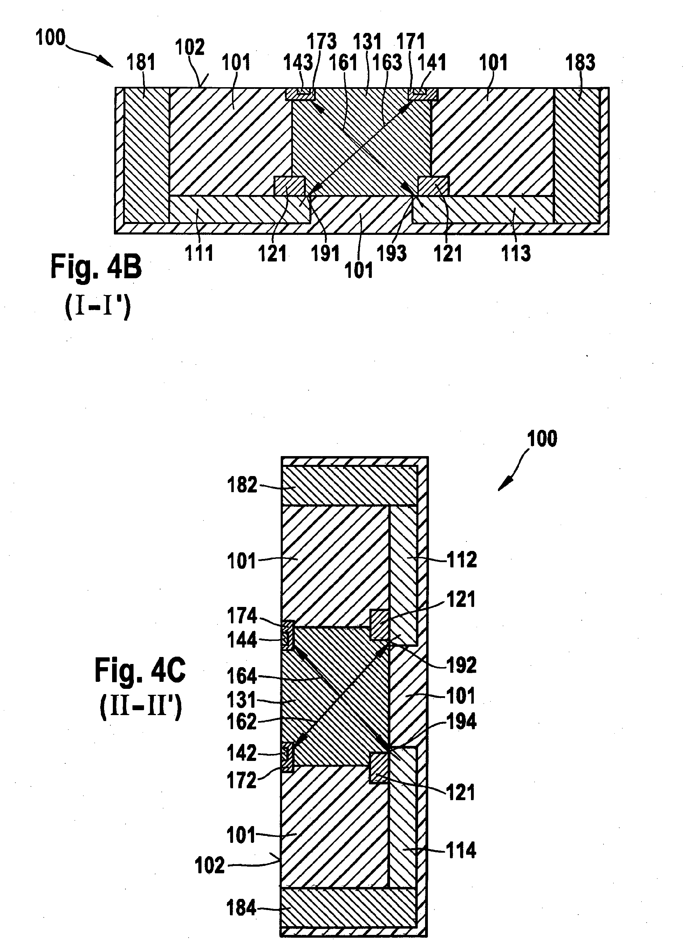

Bei dem in Fig. 4A-C gezeigten Hall-Sensorelement 100 wurden zwei Hall-Sensorstrukturen wie in Fig. 3A-C derart miteinander verschränkt, dass vier vergrabene Schichten 111-114, die über vier zugehörige Kontaktstöpsel 181-184 elektrisch anschließbar sind, den aktiven Bereich 131 von vier Seiten an entsprechenden ersten bis vierten unteren Kontaktflächen 191-194 kontaktieren, wobei zugehörige erste bis vierte obere Kontaktelektroden 141-144 mit zugehörigen Flächenkontaktbereichen 171-174 jeweils an den unteren Kontaktflächen 191-194 diagonal gegenüberliegenden Rändern ausgebildet sind. Damit erhält man zwei jeweils für sich zum spinning-current-Betrieb fähige Hall-Sensorstrukturen, die für Magnetfelder in unterschiedlichen Richtungen empfindlich sind und gemeinsam einen zweidimensionalen Messraum aufspannen. Außerdem lassen sich die vier oberen Kontaktelektroden 141-144 wie ein horizontales Hall-Sensorelement beschalten, sodass auch Magnetfelder senkrecht zur Hauptoberfläche 102 sensiert werden können. wobei ebenfalls spinning-current-Betrieb möglich ist. Damit sind Magnetfelder mit beliebiger Lage im Raum mit nur einem Hall-Sensorelement 100 sensierbar.

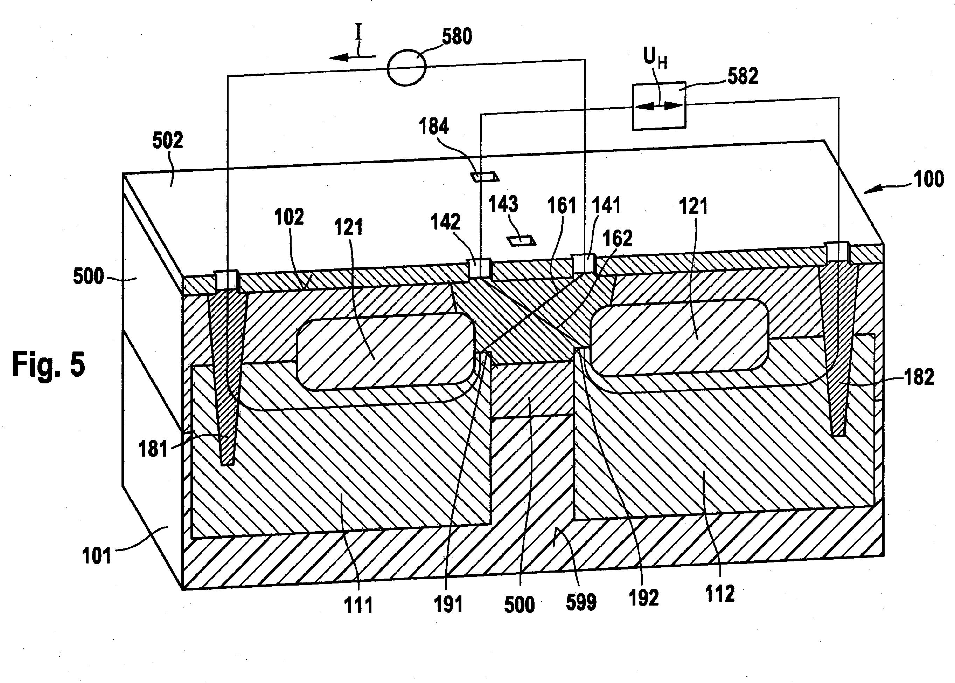

Figur 5 zeigt eine aufgeschnittene Perspektivansicht eines Hall-Sensorelements 100, bei dem deutlich wird, wie die im Substrat 102, 500 vergrabenen Schichten 111, 112 durch einen nach Ausbildung der vergrabenen Schichten 111, 112 aufgefüllten Substratbereich 500 und eine zusätzliche Deckschicht 502 abgedeckt sind. Weiterhin ist veranschaulicht, wie ein Hall-Sensorelement 100, das nach dem gleichen Prinzip wie das in Fig. 4A-C gezeigte Hall-Sensorelement aufgebaut ist, zur Messung von zur Schnittebene 599 senkrecht und damit zur Hauptoberfläche 102 parallel verlaufenden Magnetfeldern mit einer Betriebsstromquelle 580 zur Einprägung des Betriebsstroms I und einem Spannungsmesser 582 zur Messung der Hall-Spannung U_{H} beschaltet werden kann.

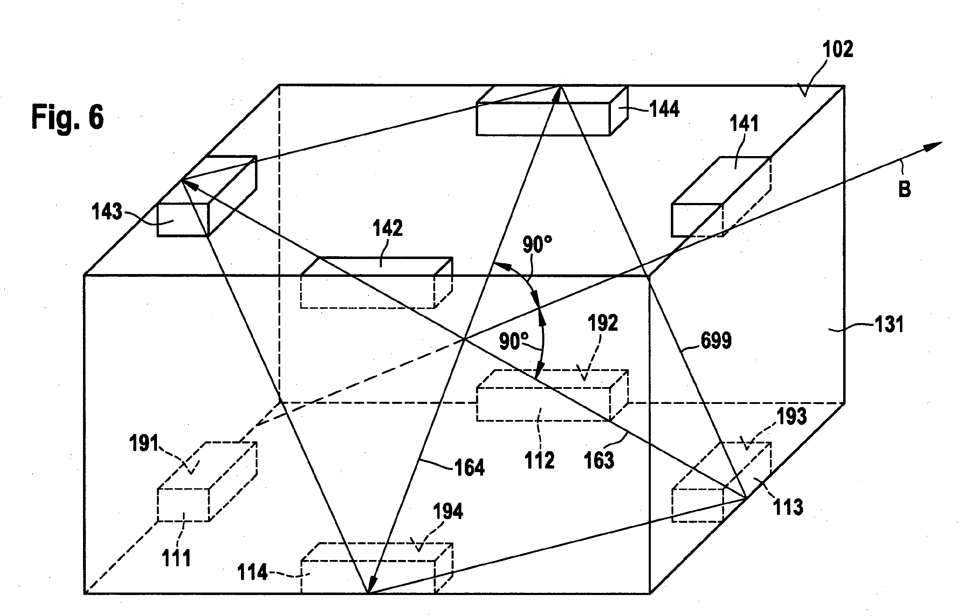

Figur 6 zeigt ein perspektivisches Prinzipschema eines Messverfahrens an einem Hall-Sensorelement mit einer geometrischen Struktur wie das in Fig. 4A-C gezeigte Hall-Sensorelement. Bei der gezeigten momentanen Beschaltung wird ein Betriebsstrom entlang einer diagonal zwischen einer unteren Kontaktfläche 193 und einer gegenüberliegenden oberen Kontaktelektrode 143 verlaufenden Verbindungslinie 163 eingeprägt, während die Hall-Spannung entlang einer Strecke entlang einer weiteren Verbindungslinie 164 abgegriffen wird, wobei beide Verbindungslinien durch eine Rotation um 90° um die vertikale Symmetrieachse des aktiven Bereichs 131 auseinander hervorgehen. Auf diese Weise werden momentan zu der von den Verbindungslinien 163, 164 aufgespannten momentanen Messebene 699 senkrecht verlaufende Magnetfeldkomponenten B sensiert.

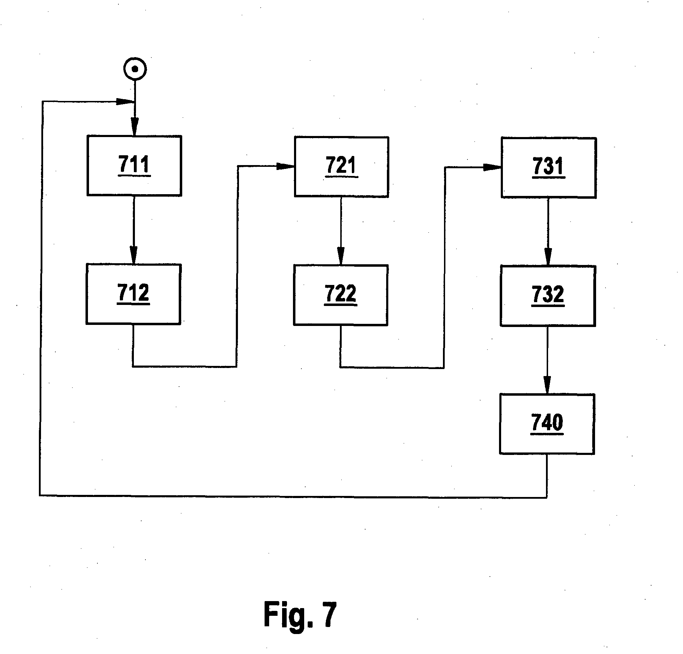

Figur 7 zeigt ein Ablaufdiagramm eines beispielhaften Messverfahrens an einem Hall-Sensorelement mit einer geometrischen Struktur wie das in Fig. 4A-C gezeigte Hall-Sensorelement, das mit Bezug auf Fig. 6 und 4A-C erläutert werden soll. In Schritt 711 wird ein erster Betriebsstrom eingeprägt, der entlang einer ersten Verbindungslinie 161 zwischen der ersten unteren Kontaktfläche 191 und der ersten oberen Kontaktelektrode 141 fließt. In Schritt 712 wird, während der eingeprägte erste Betriebsstrom fließt, eine erste Hall-Spannung entlang einer zweiten Verbindungslinie 162 zwischen der zweiten unteren Kontaktfläche 192 und der zweiten oberen Kontaktelektrode 142 abgegriffen und aus dieser eine Komponente der magnetischen Flussdichte im aktiven Bereich 131 senkrecht zu einer ersten Messebene bestimmt, die durch die erste 161 und zweite 162 Verbindungslinie aufgespannt wird.

In Schritt 721 wird der erste Betriebsstrom beendet und ein zweiter Betriebsstrom eingeprägt, der entlang der zweiten Verbindungslinie 162 fließt. In Schritt 722 wird, während der zweite Betriebsstrom fließt, eine zweite Hall-Spannung entlang einer dritten Verbindungslinie 163 zwischen der dritten unteren Kontaktfläche 193 und der dritten oberen Kontaktelektrode 143 abgegriffen und aus dieser eine Komponente der magnetischen Flussdichte im aktiven Bereich 131 senkrecht zu einer weiteren Messebene bestimmt, die durch die zweite 162 und dritte 163 Verbindungslinie aufgespannt wird.

In Schritt 731 wird der zweite Betriebsstrom beendet und ein dritter Betriebsstrom eingeprägt, der entlang einer weiteren Verbindungslinie zwischen der ersten 141 und dritten 143 oberen Kontaktelektrode fließt. In Schritt 732 wird, während der dritte Betriebsstrom fließt, eine dritte Hall-Spannung entlang noch einer weiteren Verbindungslinie zwischen der zweiten 142 und vierten 144 oberen Kontaktelektrode abgegriffen und aus dieser eine Komponente der magnetischen Flussdichte im aktiven Bereich 131 senkrecht zu einer Messebene bestimmt, die parallel zur Hauptoberfläche 102 des Substrats verläuft.

In Schritt 740 wird aus den drei in den Schritten 712, 722 und 732 bestimmten Komponenten der magnetischen Flussdichte ein Vektor berechnet, der die Stärke und Richtung der magnetischen Flussdichte im aktiven Bereich 131 in einem gewünschten, z.B. kartesischen oder polaren Koordinatensystem angibt. Sodann wird das Messverfahren ab Schritt 711 wiederholt. Sowohl bei dem obigen Durchlauf als auch bei der Wiederholung können alternierend jeweils die für Betriebsstromeinprägung und Hall-Spannungsabgriff einer der Messebenen verwendeten Kontakte miteinander in Art eines spinning-current-Verfahrens vertauscht und/oder der Vektor der magnetischen Flussdichte aus den in zwei oder mehr Durchgängen erhobenen Daten ermittelt werden.

In dem beschriebenen Verfahren werden die in Fig. 4A-C gezeigte vierte vergrabene Schicht 114 und die zugehörigen Elemente 144, 174, 184 nicht benötigt. Das Verfahren kann daher auch mit einem abgewandelten Hall-Sensorelement ausgeführt werden, bei dem diese Elemente fehlen. Andererseits kann das Verfahren aus Fig. 7 dahingehend abgewandelt werden, dass mit Bezug auf das Hall-Sensorelement 100 aus Fig. 4A-C und Fig. 6 zusätzlich oder alternativ Messungen in weiteren Messebenen durchgeführt werden, z.B. in zur Hauptoberfläche 102 geneigten Messebenen, die von der dritten 163 und vierten 164 Verbindungslinie bzw. von der vierten 164 und ersten 161 Verbindungslinie aufgespannt werden, weiterhin in zur Hauptoberfläche 102 senkrechten Messebenen, die von der ersten 161 und dritten 163 Verbindungslinie bzw. von der zweiten 162 und vierten 164 Verbindungslinie aufgespannt werden. Zur dreidimensionalen Messung von Magnetfeldern werden zweckmäßig drei Messebenen mit linear unabhängigen Normalenvektoren ausgewählt.

## Patentansprüche

1. Hall-Sensorelement (100), aufweisend:
- ein Substrat (101, 500) mit einer Hauptoberfläche (102);
- ein elektrisch leitfähiges aktives Gebiet (131), welches sich von der Hauptoberfläche (102) in das Substrat (101) erstreckt; und
- eine elektrisch leitfähige erste vergrabene Schicht (111) im Substrat (101, 500), welche das aktive Gebiet (131) an einer ersten unteren Kontaktfläche (191) kontaktiert, und
- eine erste obere Kontaktelektrode (141), welche das aktive Gebiet (131) an der Hauptoberfläche (102) kontaktiert, und
- eine zweite elektrisch leitfähige vergrabene Schicht (112), welche das aktive Gebiet (131) an einer zweiten unteren Kontaktfläche (192) kontaktiert; und
- eine zweite obere Kontaktelektrode (142), welche das aktive Gebiet (131) an der Hauptoberfläche (102) kontaktiert; und
- eine dritte (113) und vierte (114) elektrisch leitfähige vergrabene Schicht, welche das aktive Gebiet (131) an einer jeweils zugehörigen dritten (193) und vierten (194) unteren Kontaktfläche kontaktieren; und
- eine dritte (143) und vierte (144) obere Kontaktelektrode, welche das aktive Gebiet (131) an der Hauptoberfläche (102) kontaktieren;
wobei
• die erste obere Kontaktelektrode (141) derart diagonal zur ersten unteren Kontaktfläche (191) versetzt angeordnet ist, dass ein erster Betriebsstrom zwischen der unteren Kontaktfläche (191) und der ersten oberen Kontaktelektrode (141) diagonal gegenüber der Hauptoberfläche (102) geneigt verläuft, insbesondere entlang einer um 45° gegenüber der Hauptoberfläche (102) geneigten ersten Verbindungslinie (161) und
• die erste Verbindungslinie (161) zwischen der ersten unteren Kontaktfläche (191) und der ersten oberen Kontaktelektrode (141) geneigt zu einer zweiten Verbindungslinie (162) zwischen der zweiten unteren Kontaktfläche (142) und der zweiten oberen Kontaktelektrode (192) verläuft, und
• eine von der ersten (161) und zweiten (162) Verbindungslinie aufgespannte erste Ebene (599) geneigt zu einer zweiten Ebene (699) verläuft, welche von einer dritten Verbindungslinie (163) zwischen der dritten unteren Kontaktfläche (193) und der dritten oberen Kontaktelektrode (143) sowie einer vierten Verbindungslinie (164) zwischen der vierten unteren Kontaktfläche (194) und der vierten oberen Kontaktfläche (144) aufgespannt ist. und
• das elektrisch leitfähige aktive Gebiet (131) von vier Seiten von den ersten bis vierten vergrabenen elektrisch leitfähigen Schichten (111 bis 114) mit den entsprechenden ersten bis vierten unteren Kontaktflächen (191 bis 194) kontaktiert wird, und
• die zugehörigen ersten bis vierten oberen Kontaktelektroden (141 bis 144) jeweils an den unteren Kontaktflächen (191 bis 194) diagonal gegenüberliegenden Rändern ausgebildet sind.

2. Hall-Sensorelement (100) nach Anspruch 1, **dadurch gekennzeichnet, dass** wobei das Substrat (101, 500) ein Halbleitersubstrat und das aktive Gebiet (131) ein Halbleitergebiet eines ersten Leitfähigkeitstyps ist.

3. Hall-Sensorelement (100) nach Anspruch 2, **dadurch gekennzeichnet dass** beim Anlegen eines Magnetfelds an das Hall-Sensorelement zwischen der zweiten (142) und dritten (143) oberen Kontaktelektrode eine Hall-Spannung anliegt.

4. Hall-Sensorelement (100) nach Anspruch 1, **dadurch gekennzeichnet, dass** vorgesehen ist, dass die zweite Verbindungslinie (162) um 45° gegenüber der Hauptoberfläche (102) geneigt ist.

5. Hall-Sensorelement (100) nach Anspruch 1, **dadurch gekennzeichnet dass** beim Anlegen eines Magnetfelds an das Hall-Sensorelement beim Einprägen eines zweiten Betriebsstroms zwischen der zweiten vergrabenen Schicht (112) und der zweiten oberen Kontaktelektrode (142) eine zweite Hall-Spannung zwischen der unteren Kontaktfläche 193) und der dritten oberen Kontaktelektrode (143) abgegriffen werden kann.

6. Verwendung eines Hall-Sensorelements (100) nach einem der Ansprüche 1 bis 5 zur mehrdimensionalen, insbesondere dreidimensionalen Messung eines Magnetfeldes (B).

7. Verfahren zur Messung eines Magnetfeldes (B) mittels eines Hall-Sensorelements (100) nach einem der Ansprüche 1 bis 6 mit folgenden Schritten:
- Leiten (711) eines elektrischen Messstromes (I) zwischen der ersten oberen Kontaktelektrode (141) und der zur ersten oberen Kontaktelektrode (141) diagonal versetzten ersten unteren Kontaktfläche (191) entlang einer zur Hauptoberfläche (102) insbesondere um 45° geneigten ersten Verbindungslinie (161) durch das aktive Gebiet, und
- Abgreifen (712) einer Hall-Spannung (U_{H}) am aktiven Gebiet entlang einer zweiten Verbindungslinie (162), welche geneigt zu einer Verbindungslinie (161) zwischen der ersten unteren Kontaktfläche (191) und der ersten oberen Kontaktelektrode (141) verläuft, und
- Bestimmung einer Komponenten der magnetischen Flussdichte im aktiven Bereich (131) senkrecht zu einer ersten Messebene, die durch die erste und zweite Verbindungslinie aufgespannt wird, und
- Leiten (721) eines elektrischen Messstromes (I) durch das aktive Gebiet (131) über die zweite Verbindungsline (162), welche geneigt zur ersten Verbindungslinie (161) zwischen der zweiten unteren Kontaktfläche (192) und der zweiten oberen Kontaktelektrode (142) verläuft, die insbesondere um 45° gegenüber der Hauptoberfläche (102) geneigt ist, und
- Abgreifen (721) einer Hall-Spannung (U_{H}) entlang einer dritten Verbindungslinie (163) zwischen der dritten unteren Kontaktelektrode (193) und der dritten oberen Kontaktfläche (143), und
- Bestimmung einer Komponenten der magnetischen Flussdichte im aktiven Bereich (131) senkrecht zu einer weiteren Messebene, die durch die zweite und dritte Verbindungslinie aufgespannt wird, und
- Leiten (731) eines elektrischen Messstromes (I) durch das aktive Gebiet (131) über eine weitere Verbindungslinie zwischen der ersten und dritten oberen Kontaktelektrode, und
- Abgreifen (732) einer Hall-Spannung (U_{H}) zwischen der zweiten und vierten oberen Kontaktelektrode, (Anspruch 10) und
- Bestimmung einer Komponenten der magnetischen Flussdichte im aktiven Bereich (131) senkrecht zu einer Messebene, die parallel zur Hauptoberfläche (102) des Substrats verläuft, und
- Berechnung eines Vektors aus den drei bestimmten Komponenten der magnetischen Flussdichte, der die Stärke und Richtung der magnetischen Flussdichte im aktiven Bereich (131) angibt.

8. Verfahren zur dreidmensionalen Messung eines Magnetfeldes (B) mittels eines Hall-Sensorelements (100) nach einem der Ansprüche 1 bis 6 mit folgenden Schritten:
- Durchführung einer Messung zur Bestimmung der Komponenten des magnetischen Flusses im aktiven Gebiet (131) senkrecht zu einer Messebene mit den folgende Schritten:
• Leiten eines elektrischen Messstromes (I) zwischen einer ersten oberen Kontaktelektrode und einer zur ersten oberen Kontaktelektrode diagonal versetzten ersten unteren Kontaktfläche entlang einer zur Hauptoberfläche (102) insbesondere um 45° geneigten ersten Verbindungslinie durch das aktive Gebiet, und
• Abgreifen einer Hall-Spannung (U_{H}) am aktiven Gebiet entlang einer zweiten Verbindungslinie, welche geneigt zur ersten Verbindungsline verläuft, und
• Bestimmung einer Komponenten der magnetischen Flussdichte im aktiven Bereich (131) senkrecht zu einer Messebene, die durch die erste und zweite Verbindungslinie aufgespannt wird, und
- Zweimalige Wiederholung der Messung, wobei die Messebenen derart ausgewählt werden, dass sie linear unabhängige Normalvektoren aufweisen.

## Claims

1. Hall sensor element (100), comprising:
- a substrate (101, 500) having a main surface (102);
- an electrically conductive active region (131) extending from the main surface (102) into the substrate (101); and
- an electrically conductive first buried layer (111) in the substrate (101, 500), which makes contact with the active region (131) at a first bottom contact area (191) and
- a first top contact electrode (141), which makes contact with the active region (131) at the main surface (102), and
- a second electrically conductive buried layer (112), which makes contact with the active region (131) at a second bottom contact area (192); and
- a second top contact electrode (142), which makes contact with the active region (131) at the main surface (102); and
- a third (113) and fourth (114) electrically conductive buried layer, which make contact with the active region (131) at a respectively associated third (193) and fourth (194) bottom contact area; and
- a third (143) and fourth (144) top contact electrode, which make contact with the active region (131) at the main surface (102);
wherein
• the first top contact electrode (141) is arranged in a manner offset diagonally with respect to the first bottom contact area (191) in such a way that a first operating current runs between the bottom contact area (191) and the first top contact electrode (141) in a manner inclined diagonally relative to the main surface (102), in particular along a first connecting line (161) inclined by 45° relative to the main surface (102), and
• the first connecting line (161) between the first bottom contact area (191) and the first top contact electrode (141) runs in an inclined manner with respect to a second connecting line (162) between the second bottom contact area (192) and the second top contact electrode (142), and
• a first plane (599) spanned by the first connecting line (161) and second connecting line (162) runs in an inclined manner with respect to a second plane (699) spanned by a third connecting line (163) between the third bottom contact area (193) and the third top contact electrode (143) and also a fourth connecting line (164) between the fourth bottom contact area (194) and the fourth top contact electrode (144), and
• contact is made with the electrically conductive active region (131) from four sides by the first to fourth buried electrically conductive layers (111 to 114) with the corresponding first to fourth bottom contact areas (191 to 194), and
• the associated first to fourth top contact electrodes (141 to 144) are respectively formed at edges diagonally opposite the bottom contact areas (191 to 194).

2. Hall sensor element (100) according to Claim 1, **characterized in that** the substrate (101, 500) is a semiconductor substrate and the active region (131) is a semiconductor region of a first conductivity type.

3. Hall sensor element (100) according to Claim 2, **characterized in that** upon a magnetic field being applied to the Hall sensor element between the second top contact electrode (142) and third top contact electrode (143) a Hall voltage is present.

4. Hall sensor element (100) according to Claim 1, **characterized in that** provision is made for the second connecting line (162) to be inclined by 45° relative to the main surface (102).

5. Hall sensor element (100) according to Claim 1, **characterized in that** upon a magnetic field being applied to the Hall sensor element, upon a second operating current being impressed between the second buried layer (112) and the second top contact electrode (142), it is possible to tap off a second Hall voltage between the bottom contact area (193) and the third top contact electrode (143).

6. Use of a Hall sensor element (100) according to any of Claims 1 to 5 for the multi-dimensional, in particular three-dimensional, measurement of a magnetic field (B).

7. Method for measuring a magnetic field (B) by means of a Hall sensor element (100) according to any of Claims 1 to 6, comprising the following steps:
- conducting (711) an electric measurement current (I) between the first top contact electrode (141) and the first bottom contact area (191), which is offset diagonally with respect to the first top contact electrode (141), along a first connecting line (161), which is inclined in particular by 45° with respect to the main surface (102) through the active region, and
- tapping off (712) a Hall voltage (U_{H}) at the active region along a second connecting line (162), which runs in an inclined manner with respect to a connecting line (161) between the first bottom contact area (191) and the first top contact electrode (141), and
- determining a component of the magnetic flux density in the active region (131) perpendicular to a first measurement plane spanned by the first and second connecting lines, and
- conducting (721) an electric measurement current (I) through the active region (131) via the second connecting line (162), which runs in an inclined manner with respect to the first connecting line (161) between the second bottom contact area (192) and the second top contact electrode (142), which is inclined in particular by 45° relative to the main surface (102), and
- tapping off (721) a Hall voltage (U_{H}) along a third connecting line (163) between the third bottom contact area (193) and the third top contact electrode (143), and
- determining a component of the magnetic flux density in the active region (131) perpendicular to a further measurement plane spanned by the second and third connecting lines, and
- conducting (731) an electric measurement current (I) through the active region (131) via a further connecting line between the first and third top contact electrodes, and
- tapping off (732) a Hall voltage (U_{H}) between the second and fourth top contact electrodes, and
- determining a component of the magnetic flux density in the active region (131) perpendicular to a measurement plane running parallel to the main surface (102) of the substrate, and
- calculating a vector from the three determined components of the magnetic flux density, said vector indicating the strength and direction of the magnetic flux density in the active region (131).

8. Method for the three-dimensional measurement of a magnetic field (B) by means of a Hall sensor element (100) according to any of Claims 1 to 6, comprising the following steps:
- carrying out a measurement for determining the components of the magnetic flux in the active region (131) perpendicular to a measurement plane comprising the following steps:
• conducting an electric measurement current (I) between a first top contact electrode and a first bottom contact area, which is offset diagonally with respect to the first top contact electrode, along a first connecting line, which is inclined in particular by 45° with respect to the main surface (102), through the active region, and
• tapping off a Hall voltage (U_{H}) at the active region along a second connecting line, which runs in an inclined manner with respect to the first connecting line, and
• determining a component of the magnetic flux density in the active region (131) perpendicular to a measurement plane spanned by the first and second connecting lines, and
- repeating the measurement twice, wherein the measurement planes are selected in such a way that they have linearly independent normal vectors.

## Revendications

1. Elément détecteur à effet Hall (100), comprenant :
- un substrat (101, 500) comportant une surface principale (102) ;
- une zone active électriquement conductrice (131) qui s'étend depuis la surface principale (102) dans le substrat (101) ; et
- une première couche enterrée électriquement conductrice (111) dans le substrat (101, 500) qui est en contact avec la zone active (131) au niveau d'une première surface de contact inférieure (191), et
- une première électrode de contact supérieure (141) qui est en contact avec la zone active (131) au niveau de la surface principale (102), et
- une deuxième couche enterrée électriquement conductrice (112) qui est en contact avec la zone active (131) au niveau de la deuxième surface de contact inférieure (192) ; et
- une deuxième électrode de contact supérieure (142) qui est en contact avec la zone active (131) au niveau de la surface supérieure (102) ; et
- des troisième (113) et quatrième (114) couches enterrées électriquement conductrices qui sont en contact avec la zone active (131) au niveau d'une troisième (193) et d'une quatrième (194) surfaces de contact inférieures correspondantes respectives ; et
- des troisième (143) et quatrième (144) électrodes de contact supérieures qui sont en contact avec la zone active (131) au niveau de la surface supérieure (102), dans lequel
- la première électrode supérieure (141) est agencée de manière décalée en diagonale par rapport à la première surface de contact inférieure (191) afin qu'un premier courant de fonctionnement passe de manière inclinée en diagonale par rapport à la surface principale (102) entre la surface de contact inférieure (191) et la première électrode de contact supérieure (141), notamment le long d'une première ligne de connexion (161) inclinée de 45° par rapport à la surface principale (102), et
- la première ligne de connexion (161) s'étend de manière inclinée entre la première surface de contact inférieure (191) et la première électrode de contact supérieure (141) par rapport à une deuxième ligne de connexion (162) entre la deuxième surface de contact inférieure (192) et la deuxième électrode de contact supérieure (142), et
- un premier plan (599) défini par les première (161) et deuxième (162) lignes de connexion s'étend de manière inclinée par rapport à un deuxième plan (699) qui est défini par une troisième ligne de connexion (163) entre la troisième surface de contact inférieure (193) et la troisième électrode de contact supérieure (143) ainsi que par une quatrième ligne de connexion (164) entre la quatrième surface de contact inférieure (194) et la quatrième électrode de contact supérieure (144), et
- la zone active électriquement conductrice (131) est mise en contact par quatre côtés des première à quatrième couches enterrées électriquement conductrices (111 à 114) avec les première à quatrième surfaces de contact inférieures correspondantes (191 à 194), et
- les première à quatrième électrodes de contact supérieures correspondantes (141 à 144) sont respectivement formées sur les surfaces de contact inférieures (191 à 194) de bords diagonalement opposés.

2. Elément détecteur à effet Hall (100) selon la revendication 1, **caractérisé en ce que** le substrat (101, 500) est un substrat semiconducteur et **en ce que** la zone active (131) est une zone semiconductrice d'un premier type de conductivité.

3. Elément détecteur à effet Hall (100) selon la revendication 2, **caractérisé en ce que** lors de l'application d'un champ magnétique à l'élément détecteur à effet Hall, une tension Hall est présente entre les deuxième (142) et troisième (143) électrodes de contact supérieures.

4. Elément détecteur à effet Hall (100) selon la revendication 1, **caractérisé en ce qu'**il est fait en sorte que la deuxième ligne de connexion (162) soit inclinée de 45° par rapport à la surface supérieure (102).

5. Elément détecteur à effet Hall (100) selon la revendication 1, **caractérisé en ce que** lors de l'application d'un champ magnétique à l'élément détecteur à effet Hall lors de l'injection d'un deuxième courant de fonctionnement entre la deuxième couche enterrée (112) et la deuxième électrode de contact (142), une deuxième tension Hall peut être prélevée entre la surface de contact inférieure (193) et la troisième électrode de contact supérieure (143).

6. Utilisation d'un élément détecteur à effet Hall (100) selon l'une quelconque des revendications 1 à 5, pour la mesure multidimensionnelle et notamment tridimensionnelle d'un champ magnétique (B).

7. Procédé de mesure d'un champ magnétique (B) au moyen d'un élément détecteur à effet Hall (100) selon l'une quelconque des revendications 1 à 6, comprenant les étapes suivantes :
- faire passer (711) un courant électrique de mesure (I) entre la première électrode de contact supérieure (141) et la première surface de contact inférieure (191) décalée en diagonale par rapport à la première électrode de contact supérieure (141) le long d'une première ligne de connexion (161) notamment inclinée de 45° par rapport à la surface supérieure (102) à travers la zone active, et
- prélever (712) une tension Hall (U_{H}) au niveau de la zone active le long d'une deuxième ligne de connexion (162) qui s'étend de manière inclinée par rapport à une ligne de connexion (161) entre la première surface de contact inférieure (191) et la première électrode de contact supérieure (141), et
- déterminer une composante de la densité de flux magnétique dans la région active (131) perpendiculairement à un premier plan de mesure qui est défini par les première et deuxième lignes de connexion, et
- faire passer (721) un courant électrique de mesure (I) à travers la zone active (131) par l'intermédiaire de la deuxième ligne de connexion (162), qui s'étend de la manière inclinée par rapport à la première ligne de connexion (161) entre la deuxième surface de contact inférieure (192) et la deuxième électrode de contact supérieure (142), qui est notamment inclinée de 45° par rapport à la surface principale (102), et
- prélever (721) une tension Hall (U_{H}) le long d'une troisième ligne de connexion (163) entre la troisième surface de contact inférieure (193) et la troisième électrode de contact supérieure (143), et
- déterminer une composante de la densité de flux magnétique dans la zone active (131) perpendiculairement à un autre plan de mesure qui est défini par les deuxième et troisième lignes de connexion, et
- faire passer (731) un courant électrique de mesure (I) à travers la zone active (131) par l'intermédiaire d'une autre ligne de connexion entre les première et troisième électrodes de contact supérieures, et
- prélever (731) une tension Hall (U_{H}) entre les deuxième et quatrième électrodes de contact supérieures, et
- déterminer une composante de la densité de flux magnétique dans la région active (131) perpendiculairement à un plan de mesure qui s'étend parallèlement à la surface principale (102) du substrat, et
- calculer un vecteur à partir des trois composantes déterminées de la densité de flux magnétique qui fournit l'intensité et la direction de la densité de flux magnétique dans la région active (131).

8. Procédé de mesure tridimensionnelle d'un champ magnétique (B) au moyen d'un élément détecteur à effet Hall (100) selon l'une quelconque des revendications 1 à 6, comprenant les étapes suivantes :
- effectuer une mesure pour déterminer les composantes du flux magnétique dans la zone active (131) perpendiculairement à un plan de mesure conformément aux étapes suivantes :
- faire passer un courant électrique de mesure (I) entre une première électrode de contact supérieure et une première surface de contact inférieure décalée en diagonale par rapport à la première électrode de contact supérieure le long d'une première ligne de connexion notamment inclinée de 45° par rapport à la surface principale (102) à travers la zone active, et
- prélever une tension Hall (U_{H}) dans la zone active le long d'une deuxième ligne de connexion qui s'étend de manière inclinée par rapport à la première ligne de connexion, et
- déterminer une composante de la densité de flux magnétique dans la région active (131) perpendiculairement à un plan de mesure qui est défini par les première et deuxième lignes de connexion, et
- répéter deux fois la mesure en sélectionnant les plans de mesure de telle manière qu'ils présentent des vecteurs normaux linéairement indépendants.
